# EUROPÄISCHE PATENTSCHRIFT

(11) **EP 1 611 456 B1**
(45) Veröffentlichungstag und Bekanntmachung des Hinweises auf die Patenterteilung: **18.06.2008**
(21) Anmeldenummer: 03767437.1
(22) Anmeldetag: 19.11.2003
(51) Int. Cl.: G01S 7/03, H01Q 1/32, H05K 7/14, H05K 9/00

(54) **HF-MODUL UND VERFAHREN ZU DESSEN AUFBAU**
HF-MODULE AND METHOD FOR PRODUCTION THEREOF
MODULE HF ET SON PROCEDE DE PRODUCTION

(30) Priorität: 07.03.2003 DE 10309949
(43) Veröffentlichungstag der Anmeldung: 04.01.2006
(73) Patentinhaber: ROBERT BOSCH GMBH, 70442 Stuttgart (DE)
(72) Erfinder: GOTTWALD, Frank, 71287 Weissach (DE)
(86) Internationale Anmeldenummer: PCT/DE2003/003840
(87) Internationale Veröffentlichungsnummer: WO 2004/079390

(56) Entgegenhaltungen:
- DE-A- 19 644 164
- DE-A- 19 859 002
- US-B1- 6 600 103

## Beschreibung

### Stand der Technik

Die Erfindung betrifft ein Hochfrequenz (HF)-Modul mit einer HF-Leiterplatte, auf der mindestens ein erstes Antennenteil angeordnet ist, mit einem Gehäuseteil, auf dem mindestens ein zweites Antennenteil angeordnet ist, und mit einem Abschirmdeckel, wobei die HF-Leiterplatte zwischen dem Gehäuseteil und dem Abschirmdeckel montiert ist. Des Weiteren betrifft die Erfindung ein Verfahren zum Aufbau eines solchen HF-Moduls.

Ein HF-Modul der eingangs genannten Art wird im Rahmen eines Nahbereichsradars (Short Range Radar - SRR) für Kraftfahrzeuge eingesetzt. Dieses Radar arbeitet als Pulsradar bei 24,125 GHz und dient der Bestimmung von Entfernung und Geschwindigkeit von Objekten im Straßenverkehr, beispielsweise für die Funktionen Stop & Go, Precrash, Tote-Winkel-Detektion, Park-Assistent und Rückfahrhilfe.

Um die Funktion von Hochfrequenzkomponenten auf einer Leiterplatte zu gewährleisten und um andere Schaltungsteile zu entstören, wird in der Praxis ein metallisierter Abschirmdeckel verwendet, der z.B. mit Hilfe von Schrauben, Klipsen, durch Kleben, Umbördeln oder Heißverstemmen gegen die Leiterplatte gedrückt und abgedichtet wird.

Beim Aufbau eines solchen HF-Moduls muss zum einen auf eine gute Abschirmung der Hochfrequenzkomponenten geachtet werden und zum anderen auf eine exakte Ausrichtung der beiden Antennenteile gegeneinander. Außerdem sollte eine möglichst fehlerunanfällige und kostengünstige Verbindungstechnik zum Einsatz kommen.

Vorteile der Erfindung

Mit der vorliegenden Erfindung werden Maßnahmen vorgeschlagen, die einen unkomplizierten Zusammenbau des HF-Moduls ermöglichen, wobei sowohl das Gehäuseteil als auch der Abschirmdeckel einfach gegen die HF-Leiterplatte justiert werden können und mit relativ geringem Aufwand eine zuverlässige Verbindung zwischen diesen drei Teilen hergestellt werden kann.

Dies wird erfindungsgemäß dadurch erreicht, dass die HF-Leiterplatte mit mindestens einer Durchgangsöffnung versehen wird und das Gehäuseteil mit mindestens einem Zapfen ausgestattet wird. Die HF-Leiterplatte und das Gehäuseteil - und dadurch auch die beiden Antennenteile - werden gegeneinander justiert, indem der Zapfen in die Durchgangsöffnung eingeführt wird. Die Verbindung zwischen dem Gehäuseteil, der HF-Leiterplatte und dem Abschirmdeckel wird dann über den Zapfen hergestellt, der dazu einfach mit der gegenüberliegenden Oberfläche des Abschirmdeckels verbunden wird.

Da das erste Antennenteil auf der HF-Leiterplatte angeordnet ist und das zweite Antennenteil mit dem Gehäuseteil verbunden ist, können die beiden Antennenteile nur über die HF-Leiterplatte und das Gehäuseteil gegeneinander ausgerichtet werden. Erfindungsgemäß ist erkannt worden, dass die HF-Leiterplatte dazu mit Durchgangsöffnungen versehen werden kann, da diese "nicht HF-dichten" Öffnungen einfach, mit Hilfe des ohnehin erforderlichen Abschirmdeckels abgeschirmt werden können. Bei der Anordnung der Durchgangsöffnung bzw. -öffnungen ist darauf zu achten, dass die Funktion der HF-Leiterplatte nicht beeinträchtigt wird. Als besonders vorteilhaft erweist es sich mindestens zwei Durchgangsöffnungen vorzusehen, da die HF-Leiterplatte und das Gehäuseteil in diesem Fall einfach in allen drei Raumrichtungen gegeneinander ausgerichtet werden können. Erfindungsgemäß ist außerdem erkannt worden, dass der bzw. die als Justierhilfe dienenden Zapfen auch zum Herstellen der Verbindung zwischen den drei Teilen - Gehäuseteil, HF-Leiterplatte und Abschirmdeckel - genutzt werden können, indem der Zapfen mit dem Abschirmdeckel verbunden wird. Hierfür ist lediglich ein Verbindungsschritt erforderlich. Danach kann die Funktion der Antenne geprüft werden, noch bevor das HF-Modul weiter verbaut wird.

Wie bereits voranstehend in Verbindung mit der Anzahl der Durchgangsöffnungen in der HF-Leiterplatte und der Anzahl der Zapfen am Gehäuseteil angedeutet, gibt es verschiedene Möglichkeiten für die Realisierung des erfindungsgemäßen HF-Moduls bzw. des erfindungsgemäßen Verfahrens zum Aufbau eines solchen HF-Moduls.

In einer vorteilhaften Variante sind die Zapfen des Gehäuseteils mit einem Anschlag versehen. Beim Zusammenbau des HF-Moduls werden die Zapfen in die entsprechenden Durchgangsöffnungen der HF-Leiterplatte eingesteckt. Das Gehäuseteil wird dann bis zum Anschlag auf die HF-Leiterplatte gedrückt, während die Zapfen gegen den Abschirmdeckel gepresst werden. Durch den Anschlag kann einfach ein definierter Abstand zwischen Gehäuseteil und HF-Leiterplatte eingehalten werden, was insbesondere für die Funktion der Antenne wesentlich ist. Außerdem wird eine Beschädigung der HF-Leiterplatte beim Zusammenbau des HF-Moduls verhindert.

Sowohl das Gehäuseteil als auch der Abschirmdeckel werden vorteilhafterweise aus Kunststoff gefertigt, wie z.B. aus dem Kunststoff PBT. Dieser lässt sich gut metallisieren und hat einen kleinen Temperaturausdehnungskoeffizienten. Außerdem ist PBT kostengünstig. Von besonderem Vorteil ist es, wenn das Gehäuseteil aus einem von Laserstrahlen durchdringbaren Kunststoff gefertigt ist, also z.B. aus naturfarbenem oder weißem PBT, und der Abschirmdeckel aus einem von Laserstrahlen aufheizbaren Kunststoff gefertigt ist, also z.B. aus schwarzem PBT. In diesem Fall können das Gehäuseteil bzw. dessen Zapfen und der Abschirmdeckel durch Laserdurchstrahlschweißen miteinander verbunden werden. Dabei durchdringt der Laserstrahl das Zapfenmaterial und erwärmt das angrenzende Material des Abschirmdeckels. Durch die dabei entstehende Hitze und bei entsprechendem Anpressdruck verschmelzen die beiden Kunststoffbereiche und bilden eine dauerhafte Verbindung.

Zum Abdichten von Lücken zwischen der HF-Leiterplatte und dem Abschirmdeckel kann es erforderlich sein, den Abschirmdeckel zusätzlich über abschirmenden Klebstoff oder abschirmende Trockendichtungen mit der HF-Leiterplatte zu verbinden. Dazu wird der Abschirmdeckel vor dem Zusammenbau in den Klebstoff bzw. die Trockendichtungsmasse gedippt. Bei Einsatz von Klebstoff wird das HF-Modul nach dem Zusammenbau im Ofen ausgehärtet.

Die dem Zapfen des Gehäuseteils gegenüberliegende Oberfläche des Abschirmdeckels kann in unterschiedlicher Weise ausgebildet sein. Im Hinblick auf eine gute Abschirmung der Durchgangsöffnung erweist es sich als vorteilhaft, wenn im Bereich der Durchgangsöffnung ein Sockel in der Oberfläche des Abschirmdeckels ausgebildet ist, der zumindest in seinem Randbereich bis an die HF-Leiterplatte heranreicht. In diesem Fall muss der Zapfen die HF-Leiterplatte vollständig durchdringen, damit er mit dem Sockel bzw. der Sockeloberfläche verbunden werden kann. In einer anderen Variante ist auch der Abschirmdeckel mit zapfenartigen Fortsätzen ausgestattet, die ebenfalls in die Durchgangsöffnungen der Leiterplatte gesteckt werden und mit den Zapfen des Gehäuseteils verbunden werden.

### Zeichnungen

Wie bereits voranstehend ausführlich erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche und andererseits auf die nachfolgende Beschreibung eines Ausführungsbeispiels der Erfindung anhand der Zeichnungen verwiesen.

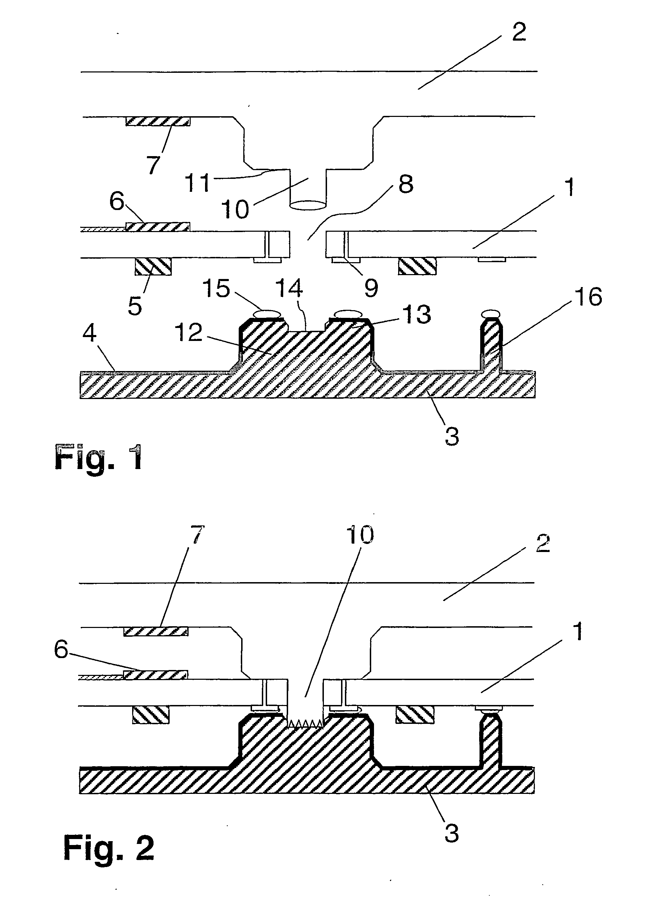

- Fig. 1: zeigt den Schnitt durch ein erfindungsgemäßes HF-Modul vor dem Zusammenbau und
- Fig. 2: zeigt das in Fig. 1 dargestellte HF-Modul nach dem Zusammenbau.

### Beschreibung des Ausführungsbeispiels

Das in den beiden Figuren dargestellte Hochfrequenz (HF)-Modul ist Teil eines Nahbereichsradars für ein Kraftfahrzeug. Es umfasst eine HF-Leiterplatte 1 als zentrale Komponente, die sandwichartig zwischen einem als Radom dienenden Gehäuseteil 2 und einem Abschirmdeckel 3 angeordnet ist. Der Abschirmdeckel 3 ist beidseitig metallisiert. Die Metallbeschichtung ist hier mit 4 bezeichnet. Auf der Unterseite der HF-Leiterplatte 1 sind verschiedene Bauelemente 5 angeordnet, auf deren Art und Funktion hier nicht näher eingegangen wird. Auf der Oberseite der HF-Leiterplatte 1 befindet sich ein erstes Antennenteil 6. Dieses erste Antennenteil 6 wirkt mit einem zweiten Antennenteil 7 zusammen, das auf der Unterseite des Gehäuseteils 2, dem ersten Antennenteil 6 gegenüberliegend angeordnet ist.

Beim Zusammenbau der drei Komponenten des HF-Moduls, HF-Leiterplatte 1, Gehäuseteil 2 und Abschirmdeckel 3, müssen die beiden Antennenteile 6 und 7 gegeneinander ausgerichtet werden. Dazu ist in der HF-Leiterplatte 1 eine Durchgangsöffnung 8 ausgebildet, die als Justierhilfe dient und die Funktion der HF-Leiterplatte 1 nicht beeinträchtigt. Rund um die Durchgangsöffnung 8 sind Durchkontaktierungen 9, sogenannte Vias, als HF-Abschirmung angeordnet. Auf der Unterseite des Gehäuseteils 2 ist ein Zapfen 10 so angeordnet, dass die beiden Antennenteile 6 und 7 durch Einstecken des Zapfens 10 in die Durchgangsöffnung 8 bestimmungsgemäß gegeneinander ausgerichtet werden. Der vertikale Abstand zwischen den beiden Antennenteilen 6 und 7 wird dabei durch einen Anschlag 11 festgelegt, der am Zapfen 10 ausgebildet ist und die maximale Einstecktiefe des Zapfens 10 bestimmt. Im hier dargestellten Ausführungsbeispiel durchdringt der Zapfen 10 die HF-Leiterplatte 1 vollständig und ragt aus deren Unterseite heraus, wenn er bis zum Anschlag 11 in die Durchgangsöffnung 8 eingeführt wird.

Der Abschirmdeckel 3 weist einen Sockel 12 auf, der der Durchgangsöffnung 8 gegenüberliegend angeordnet ist und einen erhöhten umlaufenden Rand 13 aufweist. Nach dem Zusammenbau des HF-Moduls reicht dieser umlaufende Rand 13 bis an die HF-Leiterplatte 1 heran, während der Zapfen 10 in stumpfem Kontakt mit der gegenüber dem umlaufenden Rand 13 vertieften Sockeloberfläche 14 steht.

Das Gehäuseteil 2 ist im vorliegenden Fall aus einem von Laserstrahlen durchdringbaren Kunststoff gefertigt, wie z.B. aus naturfarbenem bzw. weißem PBT. Der Abschirmdeckel 3 besteht aus einem von Laserstrahlen aufheizbaren Kunststoff, wie z.B. aus schwarzem bzw. dunklem PBT, so dass der Zapfen 10 und die Sockeloberfläche 14 durch Laserdurchstrahlschweißen miteinander verbunden werden können. Bei diesem Verfahren durchdringt der Laserstrahl das weiße Material und erwärmt den schwarzen Kunststoff. Dabei verschmelzen die aneinandergrenzenden Bereiche des Zapfens 10 und des Sockels 12 und bilden eine dauerhafte Verbindung.

Vor dem Zusammenbau des HF-Moduls wird der Abschirmdeckel 3 in einen leitfähigen elastischen Klebstoff 15 gedippt, so dass der umlaufende Rand 13 und eine innere Trennwand 16 mit Klebstoff 15 versehen werden. An Stelle des Klebstoffs kann auch ein abschirmendes Trockendichtungsmaterial verwendet werden. Dann werden das Gehäuseteil 2, die HF-Leiterplatte 1 und der Abschirmdeckel 3 übereinander angeordnet, so dass der Zapfen 10 die Durchgangsöffnung 8 durchdringt und der Sockel 12 an die Durchgangsöffnung 8 angrenzt. Anschließend werden die drei Komponenten zusammengedrückt, so dass der Zapfen 10 bis zum Anschlag 11 in die Durchgangsöffnung 8 und gegen die Sockeloberfläche 14 gepresst wird. Die drei Komponenten des HF-Moduls werden dann dauerhaft miteinander verbunden, indem der Zapfen 10 mit der Sockeloberfläche 14 verschweißt wird. Danach wird das HF-Modul im Ofen ausgehärtet. Bei Verwendung von Trockendichtungen entfällt der Ofenprozess.

## Patentansprüche

1. Hochfrequenz (HF)-Modul mit einer HF-Leiterplatte (1), auf der mindestens ein erstes Antennenteil (6) angeordnet ist, mit einem Gehäuseteil (2), auf dem mindestens ein zweites Antennenteil (7) angeordnet ist, und mit einem Abschirmdeckel (3), wobei die HF-Leiterplatte (1) zwischen dem Gehäuseteil (2) und dem Abschirmdeckel (3) montiert ist,
**dadurch gekennzeichnet, dass** die HF-Leiterplatte (1) mindestens eine Durchgangsöffnung (8) aufweist, dass das Gehäuseteil (2) mindestens einen Zapfen (10) aufweist, der in die Durchgangsöffnung (8) hineinragt, und dass der Zapfen (10) mit der gegenüberliegenden Oberfläche (14) des Abschirmdeckels (3) verbunden ist.

2. HF-Modul nach Anspruch 1, **dadurch gekennzeichnet, dass** der Zapfen (10) einen Anschlag (11) aufweist und dass der Zapfen (10) bis zu diesem Anschlag (11) in die Durchgangsöffnung (8) hineinragt.

3. HF-Modul nach einem der Ansprüche 1 oder 2, **dadurch gekennzeichnet, dass** das Gehäuseteil (2) aus einem von Laserstrahlen durchdringbaren Kunststoff gefertigt ist, dass der Abschirmdeckel (3) aus einem von Laserstrahlen aufheizbaren Kunststoff gefertigt ist und dass das Gehäuseteil (2) und der Abschirmdeckel (3) durch Laserdurchstrahlschweißen miteinander verbunden sind.

4. HF-Modul nach einem der Ansprüche 1 bis 3, **dadurch gekennzeichnet, dass** der Abschirmdeckel (3) über abschirmenden Klebstoff (15) oder abschirmende Trockendichtungen mit der HF-Leiterplatte (1) verbunden ist.

5. HF-Modul nach einem der Ansprüche 1 bis 4, **dadurch gekennzeichnet, dass** der Abschirmdeckel (3) mindestens einen Sockel (12) aufweist, der im Bereich der Durchgangsöffnung (8) der HF-Leiterplatte (1) angeordnet ist und zumindest in seinem Randbereich (13) bis an die HF-Leiterplatte (1) heranreicht, und dass der Zapfen (10) des Gehäuseteils (2) mit dem Sockel (12) des Abschirmdeckels (3) verbunden ist.

6. HF-Modul nach einem der Ansprüche 1 bis 4, **dadurch gekennzeichnet, dass** der Abschirmdeckel mindestens einen zapfenartigen Fortsatz aufweist, der ebenfalls in die Durchgangsöffnung der Leiterplatte hineinragt, und dass der Zapfen des Gehäuseteils mit dem zapfenartigen Fortsatz des Abschirmdeckels verbunden ist.

7. Verfahren zum Aufbau eines HF-Moduls mit einer HF-Leiterplatte (1), auf der mindestens ein erstes Antennenteil (6) angeordnet ist, mit einem Gehäuseteil (2), auf dem mindestens ein zweites Antennenteil (7) angeordnet ist, und mit einem Abschirmdeckel (3), wobei die HF-Leiterplatte (1) zwischen dem Gehäuseteil (2) und dem Abschirmdeckel (3) montiert wird,
**dadurch gekennzeichnet, dass** die HF-Leiterplatte (1) mit mindestens einer Durchgangsöffnung (8) versehen wird und das Gehäuseteil (2) mit mindestens einem Zapfen (10) ausgestattet wird, dass die HF-Leiterplatte (1) und das Gehäuseteil (2) - und **dadurch** auch die beiden Antennenteile (6, 7) - gegeneinander justiert werden, indem der Zapfen (10) in die Durchgangsöffnung (8) eingeführt wird, und dass der Zapfen (10) mit der gegenüberliegenden Oberfläche (14) des Abschirmdeckels (3) verbunden wird.

8. Verfahren nach Anspruch 7, **dadurch gekennzeichnet, dass** der Zapfen (10) einen Anschlag (11) aufweist und dass der Zapfen (10) bis zu diesem Anschlag (11) in die Durchgangsöffnung (8) hineingepresst wird.

9. Verfahren nach einem der Ansprüche 7 oder 8, **dadurch gekennzeichnet, dass** das Gehäuseteil (2) aus einem von Laserstrahlen durchdringbaren Kunststoff gefertigt wird, dass der Abschirmdeckel (3) aus einem von Laserstrahlen aufheizbaren Kunststoff gefertigt wird und dass das Gehäuseteil (2) und der Abschirmdeckel (3) durch Laserdurchstrahlschweißen miteinander verbunden werden.

10. Verfahren nach einem der Ansprüche 7 bis 9, **dadurch gekennzeichnet, dass** der Abschirmdeckel (3) über abschirmenden Klebstoff (15) oder abschirmende Trockendichtungen mit der HF-Leiterplatte (1) verbunden wird.

11. Verwendung eines HF-Moduls nach einem der Ansprüche 1 bis 6 im Rahmen eines Nahbereichsradars (Short Range Radar), insbesondere für Kraftfahrzeuganwendungen.

## Claims

1. Radio-frequency (RF) module having an RF printed circuit board (1), on which at least one first antenna part (6) is arranged, having a housing part (2) on which at least one second antenna part (7) is arranged, and having a screening cover (3), with the RF printed circuit board (1) being mounted between the housing part (2) and the screening cover (3),
**characterized in that** the RF printed circuit board (1) has at least one aperture opening (8), **in that** the housing part (2) has at least one pin (10) which projects into the aperture opening (8), and **in that** the pin (10) is connected to the opposite surface (14) of the screening cover (3).

2. RF module according to Claim 1, **characterized in that** the pin (10) has a stop (11), and **in that** the pin (10) projects into the aperture opening (8) as far as this stop (11).

3. RF module according to one of Claims 1 or 2,
**characterized in that** the housing part (2) is composed of a plastic through which laser beams can pass, **in that** the screening cover (3) is composed of a plastic which can be heated by laser beams, and **in that** the housing part (2) and the screening cover (3) are connected to one another by laser beam welding.

4. RF module according to one of Claims 1 to 3,
**characterized in that** the screening cover (3) is connected to the RF printed circuit board (1) by means of screening adhesive (15) or screening dry seals.

5. RF module according to one of Claims 1 to 4,
**characterized in that** the screening cover (3) has at least one cap (12) which is arranged in the area of the aperture opening (8) in the RF printed circuit board (1) and, at least in its edge area (13), extends as far as the RF printed circuit board (1), and **in that** the pin (10) on the housing part (2) is connected to the cap (12) on the screening cover (3).

6. RF module according to one of Claims 1 to 4,
**characterized in that** the screening cover has at least one pin-like projection which likewise projects into the aperture opening in the printed circuit board, and **in that** the pin on the housing part is connected to the pin-like projection on the screening cover.

7. Method for construction of an RF module having an RF printed circuit board (1) on which at least one first antenna part (6) is arranged, having a housing part (2) on which at least one second antenna part (7) is arranged, and having a screening cover (3) with the RF printed circuit board (1) being mounted between the housing part (2) and the screening cover (3),
**characterized in that** the RF printed circuit board (1) is provided with at least one aperture opening (8) and the housing part (2) is equipped with at least one pin (10), **in that** the RF printed circuit board (1) and the housing part (2), and therefore the two antenna parts (6, 7) as well, may be adjusted by inserting the pin (10) into the aperture opening (8), and **in that** the pin (10) is connected to the opposite surface (14) of the screening cover (3).

8. Method according to Claim 7, **characterized in that** the pin (10) has a stop (11), and **in that** the pin (10) is pushed into the aperture opening (8) as far as this stop (11).

9. Method according to one of Claims 7 or 8,
**characterized in that** the housing part (2) is composed of a plastic through which laser beams can pass, **in that** the screening cover (3) is composed of a plastic which can be heated by laser beams, and **in that** the housing part (2) and the screening cover (3) are connected to one another by laser beam welding.

10. Method according to one of Claims 7 to 9,
**characterized in that** the screening cover (3) is connected to the RF printed circuit board (1) by means of screening adhesive (15) or screening dry seals.

11. Use of an RF module according to one of Claims 1 to 6 for a short-range radar, in particular for motor vehicle applications.

## Revendications

1. Module haute fréquence (HF) comportant une plaque de circuit HF portant au moins une première partie d'antenne (6), une partie de boîtier (2) ayant au moins une seconde partie d'antenne (7) et un couvercle (3) formant blindage, la plaque de circuit HF (1) étant installée entre la partie de boîtier (2) et le couvercle formant blindage (3),
**caractérisé en ce que**
la plaque de circuit HF (1) comporte au moins un orifice traversant (8),
la partie de boîtier (2) comporte au moins un goujon (10) qui pénètre dans l'orifice traversant (8), et
le goujon (10) est relié à la surface (14) opposée du couvercle formant blindage (3).

2. Module haute fréquence HF selon la revendication 1,
**caractérisé en ce que**
le goujon (10) comporte une butée (11), et
le goujon (10) pénètre dans l'orifice traversant (8) jusqu'à cette butée (11).

3. Module haute fréquence HF selon l'une des revendications 1 ou 2,
**caractérisé en ce que**
la partie de boîtier (2) est fabriquée en une matière plastique que peut traverser un faisceau laser,
le couvercle formant blindage (3) est fabriqué en une matière plastique susceptible d'être chauffée par un faisceau laser, et
la partie de boîtier (2) et le couvercle formant blindage (3) sont reliés l'un à l'autre par un soudage par un faisceau laser traversant.

4. Module haute fréquence HF selon l'une des revendications 1 à 3,
**caractérisé en ce que**
le couvercle formant blindage (3) est relié par un adhésif formant blindage (15) ou des joints secs formant blindage à la plaque de circuit haute fréquence HF (1).

5. Module haute fréquence HF selon l'une des revendications 1 à 4,
**caractérisé en ce que**
le couvercle formant blindage (3) comporte au moins un socle (12) installé dans la zone de l'orifice traversant (8) de la plaque de circuit HF (1) et il arrive au moins dans sa zone marginale (13) jusqu'à la plaque de circuit HF (1), et
le tourillon (10) de la partie de boîtier (2) est relié au socle (12) du couvercle formant blindage (3).

6. Module haute fréquence HF selon l'une des revendications 1 à 4,
**caractérisé en ce que**
le couvercle formant blindage comporte au moins un prolongement en forme de goujon qui pénètre également dans l'orifice traversant de la plaque de circuit et le goujon de la partie de boîtier est relié au prolongement en forme de goujon du couvercle formant blindage.

7. Procédé de fabrication d'un module haute fréquence HF ayant une plaque de circuit HF (1) portant au moins une première partie d'antenne (6), une partie de boîtier (2) ayant au moins une seconde partie d'antenne (7) et un couvercle formant blindage (3),
la plaque de circuit à haute fréquence HF (1) étant installée entre la partie de boîtier (2) et le couvercle formant blindage (3),
**caractérisé en ce que**
la plaque de circuit HF (1) comporte au moins un orifice traversant (8), et
la partie de boîtier (2) est équipée d'au moins un goujon (10),
la plaque de circuit HF (1) et la partie de boîtier (2) et ainsi également les deux parties d'antenne (6, 7) peuvent être réglées les unes par rapport aux autres en introduisant le goujon (10) dans l'orifice traversant (8), et
le goujon (10) est relié à la surface opposée (14) du couvercle (3).

8. Procédé selon la revendication 7,
**caractérisé en ce que**
le goujon (10) comporte une butée (11), et
le goujon (10) est enfoncé dans l'orifice traversant (8) jusqu'à cette butée (11).

9. Procédé selon l'une des revendications 7 ou 8,
**caractérisé en ce que**
la partie de boîtier (2) est fabriquée en une matière plastique transparente au faisceau laser et le couvercle formant blindage (3) est fabriqué en une matière plastique qui peut être chauffée par un faisceau laser, et la partie de boîtier (2) et le couvercle formant blindage (3) sont reliés l'un à l'autre par soudage par faisceau laser traversant.

10. Procédé selon l'une des revendications 7 à 9,
**caractérisé en ce que**
le couvercle formant blindage (3) est relié à la plaque de circuit HF (1) par de l'adhésif formant blindage (15) ou des joints secs formant blindage.

11. Utilisation d'un module haute fréquence HF selon l'une des revendications 1 à 6 dans le cadre d'un radar de proximité (radar à plages courtes) notamment pour des applications à des véhicules automobiles.
